# EUROPEAN PATENT APPLICATION

(11) **EP 1 494 340 A2**
(43) Date of publication of application: **05.01.2005**
(21) Application number: 04015337.1
(22) Date of filing: 30.06.2004
(51) Int. Cl.: H02M 3/155, H02H 7/08

(54) **A system for driving a load, in particular a direct-current motor**

(30) Priority: 01.07.2003 IT TO20030504
(71) Applicant: BTM S.r.l., 10123 Torino (IT)
(72) Inventor: Marchitto, Luciano, 10015 Ivrea (Torino) (IT); Barbero, Maurizio, 10141 Torino (IT)
(74) Representative: Quinterno, Giuseppe

(57) **Abstract**

The system comprises
a voltage source (2), a first MOSFET transistor or master transistor (Q), disposed between the load (3) and the source (2) in a first circuit branch, a further MOSFET transistor, or slave transistor (Q1), disposed between the load (3) and the source (2) in a further circuit branch substantially in parallel with the first circuit branch, and control circuits (4, 5, 8, 20-22) associated with the transistors (Q, Q1).

The system further comprises a voltage supply (100) which in turn is supplied by the source (2) in operation and which can adopt selectively, in response to a control signal (CS), an operative condition and an inoperative or stand-by condition, respectively, in which it activates and suspends, respectively, the supply to the control circuits (4, 5, 8, 20-22) of a supply or biasing voltage (V_{cc}) which is necessary to permit the operation or intervention thereof, and
a detector circuit (101) which, whilst the voltage supply device (100) is in the stand-by condition, can detect the occurrence of an overvoltage in the load (3) or of a short-circuit of a master or slave transistor (Q or Q1) and, in that event, can supply to the voltage supply (100), a control signal (CS') which can bring about an abrupt change of the device (100) to the operative condition in order to permit the operation and intervention of the control circuits (4, 5, 8; 20-22).

## Description

The present invention relates to a system for driving a load, in particular for driving a direct-current electric motor.

More specifically, the subject of the invention is a driving system of the type defined in the introductory part of Claim 1.

An object of the present invention is to provide a load-driving system of this type which is more reliable and safer in operation.

This and other objects are achieved, according to the invention, by a driving system the main characteristics of which are defined in appended Claim 1.

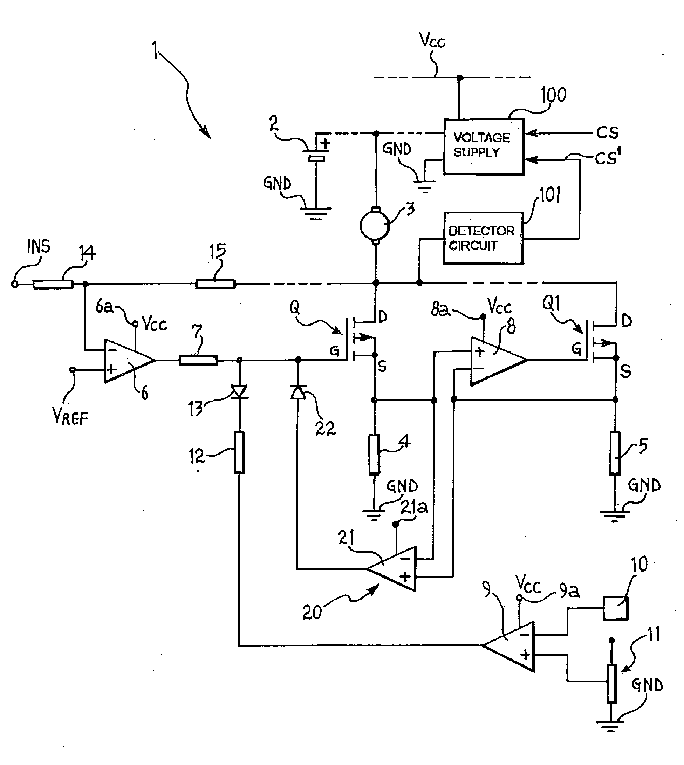

Further characteristics and advantages of the invention will become clear from the following detailed description which is given purely by way of non-limiting example with reference to the appended drawing in which Figure 1 shows an embodiment of a driving system according to the invention.

In Figure 1, a system for driving a load is generally indicated 1 and comprises a direct-current voltage source 2 such as, for example, a battery.

In the embodiment shown, the source has its negative terminal connected to the earth GND and its positive terminal connected to a terminal of a load 3 which is represented, for example, by a direct-current electric motor. The other terminal of the load 3 is connected to the earth GND via a first circuit branch which comprises an electronic driver device with controlled conduction or master device, indicated Q and a resistor which acts, in operation, as a sensor of the intensity of the current which flows through the master driver device Q.

At least one further circuit branch is connected in parallel with this circuit branch and comprises an electronic driver device with controlled conduction, or slave device Q1, and an associated resistor 5 which acts as a sensor of the current which flows through the slave device.

The master device Q and the slave device Q1 are advantageously MOSFET transistors.

The input terminal or gate of the master device Q is connected to the output of a driver amplifier 6, for example, an operational amplifier, via a resistor 7. The amplifier 6 has a supply terminal 6a which is intended to receive a direct-current supply voltage V_{cc}, preferably a stabilized voltage, supplied by a voltage-supply device 100 which in turn is supplied by the voltage source 2.

An input of the amplifier 6 is intended to receive an external control signal INS via a resistor 14 in operation and is also connected to the drain of the master transistor Q by means of a further resistor 15 for deducing the magnitude of the voltage applied to the load 3 in operation.

A further amplifier, indicated 8, for example, an operational amplifier, has a supply terminal 8a connected to the output of the voltage supply 100. The amplifier 8 has its non-inverting input and its inverting input connected to the resistors 4 and 5 in the manner shown and its output connected to the input terminal or gate of the slave transistor Q1.

A comparator, indicated 9, has an input connected to a temperature sensor 10 and another input connected to a reference or threshold voltage generator 11. The temperature sensor 10 is advantageously associated with the drain of the or of a slave transistor.

The output of the comparator 9 is connected to the input or gate of the master transistor Q via a resistor 12 and a diode 13. This comparator also has a supply terminal 9a, likewise connected to the output of the voltage supply 100.

The driver system 1 shown in the drawing further comprises a balancing circuit, generally indicated 20, for preventing the problems which may arise in operation if a short-circuit should occur in the or at least one slave transistor.

In the embodiment shown in the drawing, the balancing circuit 20 comprises a comparator 21 formed, for example, by an operational amplifier having a supply terminal 21a connected to the output of the voltage supply 100.

The comparator 21 has a first input and a second input which are connected in the manner shown to the resistors 4 and 5 which act as current sensors. The output of the comparator 21 is connected to the input or gate of the master transistor Q via a diode 22.

The voltage supply circuit 100 is arranged in a manner known *per se* to adopt selectively, in response to a control signal CS, an operative condition and an inoperative or stand-by condition, respectively, in which it activates and suspends, respectively, the supply to the various above-described amplifiers/comparators of the supply or biasing voltage V_{cc} which is necessary for their operation and intervention. In the inoperative or stand-by condition, the voltage supply 100 enables a considerable energy saving to be achieved.

The above-described driving system operates substantially in the following manner.

During normal operation, the amplifier 6 varies the conduction of current in the master transistor Q and hence the current which flows in the load 3, according to the amplitude of the external control signal INS. The comparator 8 compares the currents flowing in the master transistor Q and in the at least one slave transistor Q1, moment by moment, and drives the input or gate of the slave transistor Q1 in a manner such as to tend to equalize the currents which flow in the transistors Q, Q1.

If, for any reason, a short-circuit should occur in the master transistor Q between the drain and the source during operation, the current which is caused to flow in the motor is brought to the maximum value envisaged which corresponds to the maximum rate of rotation. In this situation, however, no damage occurs to the motor 3 or to the slave transistor/s Q1 or other components such as the resistors 4 and 5. In particular, conditions liable to lead to the development of flame do not arise.

If, on the other hand, a short-circuit should occur between the drain and the source of the or a slave transistor Q1 during operation, the current which flows through the circuit branch including that slave transistor increases and the voltage in the associated resistor 5 increases correspondingly. The comparator 21 of the balancing circuit consequently intervenes to increase the signal to the gate of the master transistor Q, causing the current conducted by the master transistor to increase correspondingly.

The effect of the balancing circuit 20 is therefore that of opposing the increase in current in the short-circuited slave transistor by increasing the conduction of current in the master transistor.

If the driving circuit 1 as a whole comprises a plurality of slave transistors with respective associated resistors acting as current sensors, the balancing circuit 20 will comprise a corresponding plurality of comparators, each of which compares the current flowing in a slave transistor with that flowing in the master transistor or with that flowing in the other or in another slave transistor, in operation.

If, as is preferable, the temperature sensor 10 is associated with the drain of the or a slave transistor, the comparator 9 can intervene effectively if that slave transistor should overheat.

If the master transistor Q should overheat, however, the thermal protection comparator 9 does not intervene. In this event, a short-circuit may be created between the drain and the source of the master transistor Q and the current flowing in the load 3 will consequently increase to the maximum value envisaged. However, as already stated, this does not lead to any major damage or, in particular, to any risk or danger of fire.

The driving system operates in the manner described above when the voltage supply 100 is in the operative condition in which it effectively supplies the necessary supply voltage V_{cc} to the various comparators/amplifiers.

A short-circuit condition, however, may arise in the master transistor Q or in the or a slave transistor whilst the voltage supply device 100 is in the inoperative or stand-by condition. In that case, in a driver circuit according to the prior art, the various amplifiers/comparators that are indicated 6, 8 and 21 herein would not be able to intervene.

Advantageously, to prevent such a possible problem, in the driving system according to the invention, a detector circuit 101 is provided for detecting the occurrence of an overvoltage in the load 3 or of a short-circuit in a master or slave driver device whilst the voltage supply device 100 is in the inoperative or stand-by condition and, in that event, supplying to the voltage-supply device 100 a control signal CS' which can bring about an abrupt change of the device 100 to the operative condition to permit the operation and intervention of the above-described amplifiers/comparators to protect the load and/or the driving system itself.

The signal CS' is not necessarily applied to an input of the voltage supply 100 which is physically distinct from that which is intended to receive the signal CS that causes the change to the stand-by condition.

In the embodiment shown, the detector circuit 101, which may be a conventional short-circuit detector, has its input connected to the drains of the driver transistors Q, Q1, or to the terminal of the load 3 which is connected to those transistors.

Naturally, the principle of the invention remaining the same, the forms of embodiment and details of construction may be varied widely with respect to those described and illustrated purely by way of non-limiting example, without thereby departing from the scope of the invention as defined in the appended claims.

## Claims

1. A system for driving a load (3), in particular, a direct-current electric motor (3), the system comprising
a direct-current voltage source (2),
a first electronic driver device with controlled conduction or master device (Q), disposed between the load (3) and the source (2) in a first circuit branch;
at least one further electronic driver device with controlled conduction, or slave device (Q1), disposed between the load (3) and the source (2) in a further circuit branch, substantially in parallel with the first circuit branch, and
control circuit means (4, 5, 8) arranged to control the conduction of current of the at least one slave device (Q1) in a manner which tends to reduce the difference between the intensities of the currents flowing in the master device (Q) and in the at least one slave device (Q1) in operation;
the driving system (1) being **characterized in that** it further comprises
balancing circuit means (20-22) arranged to generate and to apply to the input terminal of the master driver device (Q) an auxiliary conduction-control signal which tends to increase the conduction of current in the master device (Q) when the current flowing in the or a slave driver device (Q1) in operation exceeds the current flowing in the master driver device (Q),
a voltage supply device (100) which in turn is supplied by the source (2) in operation, and which can adopt selectively, in response to a control signal (CS), an operative condition and an inoperative or stand-by condition, in which it activates and suspends, respectively, the supply to the control circuit means (4, 5, 8) and to the balancing circuit means (20-22) of a supply or biasing voltage (V_{cc}) which is necessary to permit the operation or intervention thereof, and
detector means (101) which, whilst the voltage supply device (100) is in the inoperative or stand-by condition, can detect the occurrence of an overvoltage in the load (3) or of a short-circuit of a master or slave driver device (Q or Q1) and, **in that** event, can supply to the voltage supply device (100), a control signal (CS') which can bring about an abrupt change of the device (100) to the operative condition in order to permit the operation and intervention of the control and balancing circuit means (4, 5, 8; 20-22).

2. A driving system according to Claim 1, further comprising a thermal protection circuit (9-13) which is supplied by the voltage supply device (100) and can apply to the input terminal of the master driver device (Q) a signal which tends to reduce the conduction of current in the master device (Q) when a temperature sensor (10) associated with the or a slave driver device (Q1) indicates that the temperature in the region of that slave driver device (Q1) exceeds a predetermined value.

3. A driving system according to Claim 1 or Claim 2 in which the master driver device (Q) and the at least one slave driver device (Q1) are FET transistors, in particular MOSFET transistors.

4. A driving system according to any one of the preceding claims in which there is associated with each of the circuit branches a respective current sensor device (4, 5), in particular a resistor disposed in series with the corresponding master driver device (Q) or slave driver device (Q1), and in which the balancing circuit means (20) comprise at least one operational amplifier (21) having a supply terminal (21a) connected to the voltage supply device (100) and a first input and a second input which are connected, respectively, to the current sensor device (4) associated with the master device (Q) and to the current sensor device (5) associated with the at least one slave device (Q1), and an output which is connected to the input terminal of the master driver device (Q).

5. A driving system according to Claim 4 in which the control circuit means comprise an operational amplifier (8) having a supply terminal (8a) connected to the voltage supply device (100) and a first input and a second input which are connected, respectively, to the current sensor device (4) associated with the master driver device (Q) and to the current sensor device (5) associated with the at least one slave driver device (Q1), and an output which is connected to an input terminal of the corresponding slave driver device (Q1).

6. A driving system according to Claims 2 and 3 in which the temperature sensor (10) is associated with the drain of the or a slave MOSFET transistor (Q1).

7. A driving system according to any one of the preceding claims in which the detector means (101) are arranged to detect an excessive variation in the potential of the terminal of the load (3) which is connected to the master driver device (Q) and to the at least one slave driver device (Q1).

8. A driving system according to Claim 7 in which the load (3) is interposed between the positive terminal of the voltage source (2) and the master and slave driver devices (Q; Q1) which in turn are interposed between the load (3) and the negative terminal (GND) of the source (2); the detector means (101) being arranged to detect an excessive lowering of the potential of the terminal of the load (3) which is connected to the master and slave driver devices (Q; Q1).
